# EUROPEAN PATENT APPLICATION

(11) **EP 4 447 636 A1**
(43) Date of publication of application: **16.10.2024**
(21) Application number: 23818915.3
(22) Date of filing: 18.05.2023
(51) Int. Cl.: H10K 50/824, H10K 59/12

(54) **DISPLAY PANEL AND DISPLAY APPARATUS**

(30) Priority: 09.06.2022 CN 202210645736
(71) Applicant: Boe Technology Group Co., Ltd., Beijing 100015 (CN)
(72) Inventor: HAN, Ying, Beijing 100176 (CN); XU, Pan, Beijing 100176 (CN); ZHANG, Xing, Beijing 100176 (CN); LUO, Chengyuan, Beijing 100176 (CN); ZHAO, Donghui, Beijing 100176 (CN); ZHANG, Dacheng, Beijing 100176 (CN)
(74) Representative: Hoffmann Eitle
(86) International application number: PCT/CN2023/094978
(87) International publication number: WO 2023/236750

(57) **Abstract**

A display panel, comprising a substrate, an auxiliary electrode, a connection portion, a light-emitting layer and a cathode layer. The auxiliary electrode is located on the substrate. The connection portion is located on the side of the auxiliary electrode away from the substrate, the connection portion comprising a first connection pattern, a second connection pattern and a third connection pattern which are successively stacked in the direction away from the substrate, the first connection pattern being electrically connected to the auxiliary electrode, and an edge of the second connection pattern retracting relative to an edge of the third connection pattern. The light-emitting layer comprises a first light-emitting pattern and a second light-emitting pattern, the first light-emitting pattern being located around the second light-emitting pattern and being separated from the second light-emitting pattern, and the second light-emitting pattern being located on the side of the third connection pattern away from the substrate. The cathode layer is located on the side of the light-emitting layer away from the substrate, the cathode layer passing through a gap between the first light-emitting pattern and the second light-emitting pattern and being in electrical contact with at least one of the first connection pattern, the second connection pattern, and the third connection pattern.

## Description

This application claims priority to Chinese Patent Application No. 202210645736.9, filed on June 9, 2022, which is incorporated herein by reference in its entirety.

### TECHNICAL FIELD

The present disclosure relates to the field of display technologies, and in particular, to a display panel and a display apparatus.

### BACKGROUND

Compared with passive light-emitting liquid crystal displays (LCDs), active light-emitting organic light-emitting diode (OLED) displays have advantages such as fast response, high contrast and wide viewing angles, and are easy to achieve flexible display. Therefore, the OLED displays are widely used.

There are two light-emitting ways of OLED displays: top emission and bottom emission. Top emission OLED displays require the use of transparent or translucent cathodes. In medium-sized OLED displays and large-sized OLED displays, due to high resistance of the transparent electrode and low thickness uniformity of the translucent cathode, it is easy to cause a large cathode voltage drop (IR Drop), which finally leads to brightness uniformity of the display panel.

How to reduce the cathode voltage drop and improve the brightness uniformity of the display panel has become one of the main research issues for those skilled in the art.

### SUMMARY

In an aspect, a display panel is provided. The display panel includes a substrate, an auxiliary electrode, a connection portion, a light-emitting layer and a cathode layer. The auxiliary electrode is located on the substrate. The connection portion is located on a side of the auxiliary electrode away from the substrate. The connection portion includes a first connection pattern, a second connection pattern, and a third connection pattern that are sequentially stacked in a direction away from the substrate; the first connection pattern is electrically connected to the auxiliary electrode, and an edge of the second connection pattern is indented inward relative to an edge of the third connection pattern. The light-emitting layer includes a first light-emitting pattern and a second light-emitting pattern; the first light-emitting pattern is located around and separated from the second light-emitting pattern, and the second light-emitting pattern is located on a side of the third connection pattern away from the substrate. The cathode layer is located on a side of the light-emitting layer away from the substrate; the cathode layer passes through a gap between the first light-emitting pattern and the second light-emitting pattern to be in electrical contact with at least one of the first connection pattern, the second connection pattern and the third connection pattern.

In some embodiments, an orthographic projection of the third connection pattern on the substrate is located inside an orthographic projection of the first connection pattern on the substrate, and a distance exists between a border of the orthographic projection of the third connection pattern on the substrate and a border of the orthographic projection of the first connection pattern on the substrate.

In some embodiments, the display panel further includes a circuit structure layer located between the connection portion and the substrate; the circuit structure layer includes a semiconductor layer, a gate layer and a source-drain layer; and the auxiliary electrode is located in at least one layer of the semiconductor layer, the gate layer and the source-drain layer.

In some embodiments, the cathode layer includes a first contact portion and a second contact portion; the first contact portion is located on a side of the first light-emitting pattern away from the substrate, and the second contact portion is located on a side of the second light-emitting pattern away from the substrate.

In some embodiments, a gap exists between the second connection pattern and the first light-emitting pattern, and the gap exposes part of a surface of the first connection pattern; the first contact portion is in electrical contact with a side surface of the first light-emitting pattern proximate to the second connection pattern and an exposed surface of the first connection pattern; and/or the first contact portion is in electrical contact with a side surface of the second connection pattern.

In some embodiments, the second contact portion covers a side surface of the second light-emitting pattern proximate to the first light-emitting pattern and is in electrical contact with a side surface of the third connection pattern.

In some embodiments, the first contact portion and the second contact portion are separated from each other.

In some embodiments, the display panel further includes a planarization layer located between the connection portion and the auxiliary electrode; the planarization layer includes a first through hole exposing the auxiliary electrode; and the first connection pattern is in contact with the auxiliary electrode through the first through hole.

In some embodiments, the first through hole includes a first end opening and a second end opening, the first end opening is farther away from the substrate than the second end opening, and a size of the first end opening is larger than a size of the second end opening. A hole wall of the first through hole is inclined relative to a plane where the substrate is located, and the edge of the second connection pattern extends onto the hole wall of the first through hole.

In some implementations, the cathode layer includes a first contact portion and a second contact portion that are separated from each other, and edges of the first contact portion and the second contact portion that are proximate to each other are located on the hole wall of the first through hole.

In some embodiments, the display panel further includes a passivation layer located between the planarization layer and the auxiliary electrode; the passivation layer includes a second through hole that exposes at least part of a surface of the auxiliary electrode, and the second through hole communicates with the first through hole. The first connection pattern is in contact with the auxiliary electrode through the first through hole and the second through hole.

In some embodiments, an orthographic projection of the second through hole on the substrate is located inside an orthographic projection of the auxiliary electrode on the substrate.

In some embodiments, an orthographic projection of the second through hole on the substrate is located inside an orthographic projection of the second end opening of the first through hole on the substrate, and a distance exists between a border of the orthographic projection of the second through hole on the substrate and a border of the orthographic projection of the second end opening on the substrate.

In some embodiments, an orthographic projection of the second through hole on the substrate is rectangular in shape, and an orthographic projection of the second end opening of the first through hole on the substrate is rectangular in shape.

In some embodiments, the display panel further includes a pixel defining layer located on a side of the connection portion away from the substrate; the pixel defining layer includes a third through hole that exposes part of a surface of the first connection pattern away from the substrate and side surfaces of the second connection pattern and the third connection pattern. The light-emitting layer is in contact with the first connection pattern and the third connection pattern through the third through hole.

In some embodiments, the display panel further includes an anode layer located between the light-emitting layer and the auxiliary electrode; the connection portion is located in the anode layer; the anode layer further includes an anode; the pixel defining layer further includes a pixel opening exposing part of a surface of the anode; and the pixel opening and the third through hole are staggered from each other.

In some embodiments, in a case where the display panel further includes a planarization layer and the planarization layer includes a first through hole, an orthographic projection of a first end opening of the first through hole on the substrate is located inside an orthographic projection of the third through hole on the substrate, and a distance exists between a border of the orthographic projection of the first end opening on the substrate and a border of the orthographic projection of the third through hole on the substrate.

In some embodiments, the display panel includes a plurality of sub-pixels that are arranged in rows along a first direction and in columns along a second direction; the first direction intersects the second direction. The display panel includes a plurality of auxiliary electrodes; at least one auxiliary electrode extends in the first direction and is located between two adjacent rows of sub-pixels; and/or at least one auxiliary electrode extends in the second direction and is located between two adjacent columns of sub-pixels.

In some embodiments, one auxiliary electrode is connected to first connection patterns of multiple connection portions.

In another aspect, a display apparatus is provided. The display apparatus includes the display panel as described in any one of the above embodiments.

### BRIEF DESCRIPTION OF THE DRAWINGS

In order to describe technical solutions in the present disclosure more clearly, the accompanying drawings to be used in some embodiments of the present disclosure will be introduced briefly. Obviously, the accompanying drawings to be described below are merely drawings of some embodiments of the present disclosure, and a person of ordinary skill in the art can obtain other drawings according to these drawings. In addition, the accompanying drawings in the following description may be regarded as schematic diagrams, but are not limitations on actual sizes of products, actual processes of methods and actual timings of signals involved in the embodiments of the present disclosure.
FIG. 1 is a structural diagram of a display panel, in accordance with some embodiments;
FIG. 2 is a top view of a connection portion, in accordance with some embodiments;
FIG. 3A is a top view of another connection portion, in accordance with some embodiments;
FIG. 3B is a top view of yet another connection portion, in accordance with some embodiments;
FIG. 4 is a structural diagram of an overlapping portion between a cathode layer and a connection portion, in accordance with some embodiments;
FIG. 5 is a structural diagram of an overlapping portion between another cathode layer and a connection portion, in accordance with some embodiments;
FIG. 6 is a partial enlarged view of the CC region in FIG. 1;
FIG. 7A is a structural diagram of another display panel, in accordance with some embodiments;
FIG. 7B is a structural diagram of yet another display panel, in accordance with some embodiments;
FIG. 8 is a diagram showing a circuit structure of a pixel circuit, in accordance with some embodiments;
FIG. 9 is a layout diagram of a display panel, in accordance with some embodiments;
FIG. 10 is a top view of yet another connection portion, in accordance with some embodiments;
FIG. 11 is a top view of yet another connection portion, in accordance with some embodiments;
FIG. 12 is a structural diagram of yet another display panel, in accordance with some embodiments;
FIG. 13 is a structural diagram of yet another display panel, in accordance with some embodiments;
FIG. 14 is a flow diagram of a method for manufacturing a display panel, in accordance with some embodiments; and
FIG. 15 is a structural diagram of a display apparatus, in accordance with some embodiments.

### DETAILED DESCRIPTION

The technical solutions in some embodiments of the present disclosure will be described clearly and completely with reference to the accompanying drawings. Obviously, the described embodiments are merely some but not all of embodiments of the present disclosure. All other embodiments obtained on the basis of the embodiments of the present disclosure by a person of ordinary skill in the art shall be included in the protection scope of the present disclosure.

Unless the context requires otherwise, throughout the description and claims, the term "comprise" and other forms thereof such as the third-person singular form "comprises" and the present participle form "comprising" are construed as an open and inclusive meaning, i.e., "included, but not limited to". In the description of the specification, terms such as "one embodiment", "some embodiments", "exemplary embodiments", "example", "specific example" or "some examples" are intended to indicate that specific features, structures, materials or characteristics related to the embodiment(s) or example(s) are included in at least one embodiment or example of the present disclosure. Schematic representations of the above terms do not necessarily refer to the same embodiment(s) or example(s). In addition, the specific features, structures, materials, or characteristics described herein may be included in any one or more embodiments or examples in any suitable manner.

Hereinafter, the terms such as "first" and "second" are used for descriptive purposes only, but are not to be construed as indicating or implying the relative importance or implicitly indicating the number of indicated technical features. Thus, the feature defined with "first" or "second" may explicitly or implicitly include one or more of the features. In the description of the embodiments of the present disclosure, the term "a plurality of / the plurality of" means two or more unless otherwise specified.

In the description of some embodiments, the expressions "coupled" and "connected" and derivatives thereof may be used. For example, the term "connected" may be used in the description of some embodiments to indicate that two or more components are in direct physical or electrical contact with each other. For another example, the term "coupled" may be used in the description of some embodiments to indicate that two or more components are in direct physical or electrical contact. However, the term "coupled" or "communicatively coupled" may also mean that two or more components are not in direct contact with each other, but still cooperate or interact with each other. The embodiments disclosed herein are not necessarily limited to the context herein.

The phrase "at least one of A, B and C" has the same meaning as the phrase "at least one of A, B or C", and they both include following combinations of A, B and C: only A, only B, only C, a combination of A and B, a combination of A and C, a combination of B and C, and a combination of A, B and C.

The phrase "A and/or B" includes the following three combinations: only A, only B, and a combination of A and B.

In addition, the phrase "based on" used is meant to be open and inclusive, since a process, step, calculation or other action that is "based on" one or more of the stated conditions or values may, in practice, be based on additional conditions or values exceeding those stated.

The term such as "about", "substantially" or "approximately" as used herein includes a stated value and an average value within an acceptable range of deviation of a particular value determined by a person of ordinary skill in the art, considering measurement in question and errors associated with measurement of a particular quantity (i.e., limitations of a measurement system).

The term such as "parallel", "perpendicular" or "equal" as used herein includes a stated condition and a condition similar to the stated condition, a range of the similar condition is within an acceptable range of deviation, and the acceptable range of deviation is determined by a person of ordinary skill in the art, considering measurement in question and errors associated with measurement of a particular quantity (i.e., limitations of a measurement system). For example, the term "parallel" includes absolute parallelism and approximate parallelism, and an acceptable range of deviation of the approximate parallelism may be, for example, a deviation within 5°; the term "perpendicular" includes absolute perpendicularity and approximate perpendicularity, and an acceptable range of deviation of the approximate perpendicularity may also be, for example, a deviation within 5°; and the term "equal" includes absolute equality and approximate equality, and an acceptable range of deviation of the approximate equality may be, for example, that a difference between two equals is less than or equal to 5% of either of the two equals.

It should be understood that, when a layer or element is referred to as being on another layer or substrate, it may be that the layer or element is directly on the another layer or substrate, or it may be that intervening layer(s) exist between the layer or element and the another layer or substrate.

Exemplary embodiments are described herein with reference to sectional views and/or plan views as idealized exemplary drawings. In the drawings, thicknesses of layers and sizes of regions are enlarged for clarity. Variations in shapes relative to the accompanying drawings due to, for example, manufacturing technologies and/or tolerances may be envisaged. Therefore, the exemplary embodiments should not be construed to be limited to the shapes of regions shown herein, but to include deviations in the shapes due to, for example, manufacturing. For example, an etched region shown in a rectangular shape generally has a feature of being curved. Therefore, the regions shown in the accompanying drawings are schematic in nature, and their shapes are not intended to show actual shapes of regions in an apparatus, and are not intended to limit the scope of the exemplary embodiments.

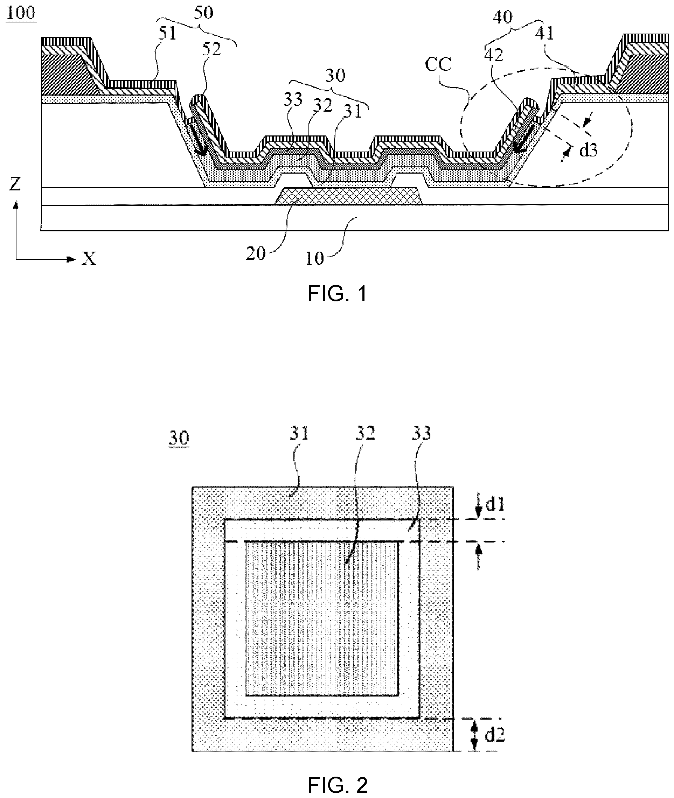

As shown in FIG. 1, some embodiments of the present disclosure provide a display panel 100. The display panel 100 includes a substrate 10, an auxiliary electrode 20, a connection portion 30, a light-emitting layer 40 and a cathode layer 50.

The substrate 10 can be a flexible substrate. In this case, a material of the substrate 10 may include, for example, polyimide (PI). Alternatively, the substrate 10 can be a rigid substrate 10. In this case, a material of the substrate 10 may include, for example, glass.

The auxiliary electrode 20 is located on the substrate 10. For example, the material of the auxiliary electrode 20 may be metal, such as aluminum, copper, or molybdenum.

The connection portion 30 is located on a side of the auxiliary electrode 20 away from the substrate 10. The connection portion 30 includes a first connection pattern 31, a second connection pattern 32, and a third connection pattern 33 that are sequentially stacked in a direction away from the substrate 10. The first connection pattern 31 is electrically connected to the auxiliary electrode 20, and an edge of the second connection pattern 32 is indented inward relative to an edge of the third connection pattern 33.

As shown in FIG. 1, the first connection pattern 31, the second connection pattern 32 and the third connection pattern 33 may be stacked in sequence in a direction Z perpendicular to the substrate 10 and away from the substrate 10.

The light-emitting layer 40 includes a first light-emitting pattern 41 and a second light-emitting pattern 42. The first light-emitting pattern 41 is located around and separated from the second light-emitting pattern 42. The second light-emitting pattern 42 is located on a side of the third connection pattern 33 away from the substrate 10.

In some examples, the light-emitting layer 40 may be formed by using an evaporation process.

The cathode layer 50 is located on a side of the light-emitting layer 40 away from the substrate 10. The cathode layer 50 passes through a gap between the first light-emitting pattern 41 and the second light-emitting pattern 42 to be in electrical contact with at least one of the first connection pattern 31, the second connection pattern 32 and the third connection pattern 33.

As shown in FIG. 2, the expression "the edge of the second connection pattern 32 is indented inward relative to the edge of the third connection pattern 33" can be that an orthographic projection of the second connection pattern 32 on the substrate 10 is located within an orthographic projection of the third connection pattern 33 on the substrate 10, and there is a distance d1 between a border of the orthographic projection of the second connection pattern 32 on the substrate 10 and a border of the orthographic projection of the third connection pattern 33 on the substrate 10.

In some examples, the distance d1 between the border of the orthographic projection of the second connection pattern 32 on the substrate 10 and the border of the orthographic projection of the third connection pattern 33 on the substrate 10 may be in a range of 0.25 micrometers to 1.75 micrometers. For example, the distance d1 may be 0.25 microns, 0.5 microns, 0.75 microns, 1.0 microns, 1.25 microns, 1.5 microns, 1.75 microns, etc.

It can be understood that, at different positions of the border of the orthographic projection of the second connection pattern 32 on the substrate 10, distances between the border of the orthographic projection of the second connection pattern 32 on the substrate 10 and the border of the orthographic projection of the third connection pattern 33 on the substrate 10 may be different.

For example, the edge of the second connection pattern 32 is indented inward relative to the edge of the third connection pattern 33, which may be that the edge of the second connection pattern 32 is indented inward relative to the edge of the third connection pattern 33 along the direction indicated by the "thick arrow" in FIG. 1.

With such arrangement, after the connection portion 30 is formed, it can be easier for the light-emitting layer 40 to break at the border of the third connection pattern 33 when the light-emitting layer 40 is formed, thereby forming the second light-emitting pattern 42 on the side of the third connection pattern 33 away from the substrate 10 and the first light-emitting pattern 41 located around and separated from the second light-emitting pattern 42. In addition, it can avoid situations where the border of the third connection pattern 33 exceeds the border of the second connection pattern 32 by too much, the edge of the third connection pattern 33 sags, the light-emitting layer 40 is not easily broken, and the cathode layer 50 is difficult to be in contact with the first connection pattern 31, the second connection pattern 32 or the third connection pattern 33.

For example, the first connection pattern 31 and the third connection pattern 33 may be made of the same material. For example, the material of the first connection pattern 31 and the third connection pattern 33 includes indium tin oxide (ITO).

A thickness of the first connection pattern 31 and a thickness of the third connection pattern 33 may be the same as or different. In the case where the thicknesses of the first connection pattern 31 and the third connection pattern 33 are the same, the thicknesses of the first connection pattern 31 and the third connection pattern 33 may be in a range of 600 angstroms to 800 angstroms. For example, the thicknesses of the first connection pattern 31 and the third connection pattern 33 may be 600 angstroms, 650 angstroms, 700 angstroms, 750 angstroms, or 800 angstroms.

The second connection pattern 32 may be of a single-layer structure or a multi-layer structure. In the case where the second connection pattern 32 is of the single-layer structure, the material of the second connection pattern 32 may include metal, such as aluminum.

In some examples, in the case where the second connection pattern 32 is of the multi-layer structure, the second connection pattern 32 may include a molybdenum metal layer, an aluminum metal layer and a molybdenum metal layer that are sequentially stacked in the direction away from the substrate 10.

A thickness of the molybdenum metal layer may be in a range of 400 angstroms to 800 angstroms. For example, the thickness of the molybdenum metal layer may be 400 angstroms, 500 angstroms, 600 angstroms, 700 angstroms, 800 angstroms, etc. The thicknesses of the molybdenum metal layers located on both sides of the aluminum metal layer may be the same or different. For example, the thickness of the molybdenum metal layer located between the aluminum metal layer and the substrate 10 may be 500 angstroms, and the thickness of the molybdenum metal layer located on a side of the aluminum metal layer away from the substrate 10 may be 700 angstroms. A thickness of the aluminum metal layer may be, for example, in a range of 4500 angstroms to 5500 angstroms. For example, the thickness of the aluminum metal layer may be 4500 angstroms, 5000 angstroms, 5500 angstroms, etc.

In some other examples, in the case where the second connection pattern 32 is of the multi-layer structure, the second connection pattern 32 may include a molybdenum metal layer and an aluminum metal layer that are sequentially stacked in the direction away from the substrate 10. In this case, a thickness of the molybdenum metal layer may be in a range of 400 angstroms to 800 angstroms. For example, the thickness of the molybdenum metal layer may be 400 angstroms, 500 angstroms, 600 angstroms, 700 angstroms, 800 angstroms, etc. A thickness of the aluminum metal layer may be in a range of 5000 angstroms to 6000 angstroms. For example, the thickness of the aluminum metal layer may be 5000 angstroms, 5500 angstroms, 6000 angstroms, etc.

Shapes of the first connection pattern 31, the second connection pattern 32 and the third connection pattern 33 are not limited in the present disclosure, as long as electrical contact can be achieved with the cathode layer 50. In some possible embodiments, the orthographic projection of the first connection pattern 31 on the substrate 10, the orthographic projection of the second connection pattern 32 on the substrate 10, and the orthographic projection of the third connection pattern 33 on the substrate 10 can all be substantially rectangular in shape (their shapes including a rectangle and square).

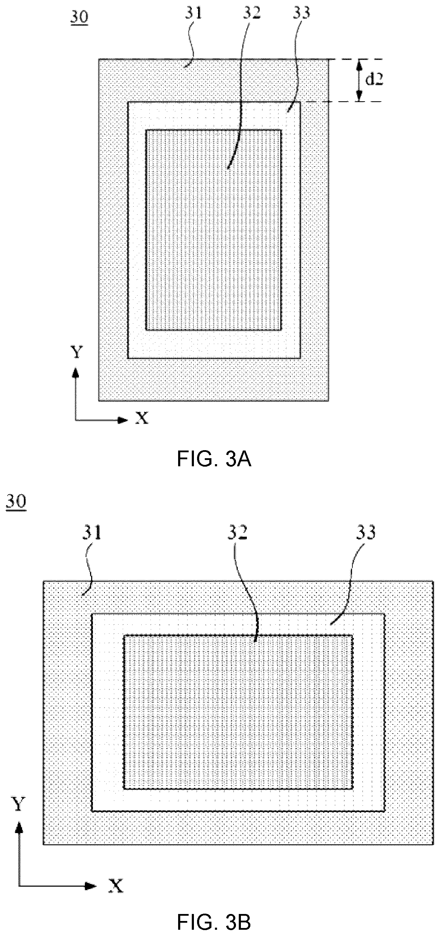

FIG. 2 shows an example where the orthographic projection of the first connection pattern 31 on the substrate 10, the orthographic projection of the second connection pattern 32 on the substrate 10, and the orthographic projection of the third connection pattern 33 on the substrate 10 are all square in shape. FIGS. 3A and 3B show examples where the orthographic projection of the first connection pattern 31 on the substrate 10, the orthographic projection of the second connection pattern 32 on the substrate 10, and the orthographic projection of the third connection pattern 33 on the substrate 10 are all rectangular in shape.

It can be understood that, the expression "the orthographic projection of the first connection pattern 31 on the substrate 10, the orthographic projection of the second connection pattern 32 on the substrate 10, and the orthographic projection of the third connection pattern 33 on the substrate 10 can be substantially rectangular in shape" means that the orthographic projection of the first connection pattern 31 on the substrate 10, the orthographic projection of the second connection pattern 32 on the substrate 10, and the orthographic projection of the third connection pattern 33 on the substrate 10 are in a shape of an overall rectangle, but it is not limited to a standard rectangle. That is, "rectangle" herein includes not only the standard rectangle but also a shape similar to the rectangle in consideration of process conditions.

In the case where the orthographic projection of the first connection pattern 31 on the substrate 10, the orthographic projection of the second connection pattern 32 on the substrate 10, and the orthographic projection of the third connection pattern 33 on the substrate 10 are all in the shape of the rectangle, as shown in FIGS. 3A and 3B, an extending direction of the long side of the rectangle may be parallel to the first direction X of the substrate 10, or may be parallel to the second direction Y of the substrate 10.

In the above embodiments of the present disclosure, there is no limitation on sizes of the first connection pattern 31, the second connection pattern 32, and the third connection pattern 33, and they can be designed according to actual needs, as long as the electrical contact can be achieved between the cathode layer 50 and one of the first connection pattern 31, the second connection pattern 32 and the third connection pattern 33.

The cathode layer 50 is in electrical contact with at least one of the first connection pattern 31, the second connection pattern 32 and the third connection pattern 33, which may be that the cathode layer 50 is in contact with one of the first connection pattern 31, the second connection pattern 32 and the third connection pattern 33. For example, the cathode layer 50 is in electrical contact with the first connection pattern 31.

Alternatively, the cathode layer 50 is in electrical contact with at least one of the first connection pattern 31, the second connection pattern 32 and the third connection pattern 33, which may be that the cathode layer 50 is in electrical contact with two of the first connection pattern 31, the second connection pattern 32 and the third connection pattern 33. At this time, the cathode layer 50 may be in contact with both the first connection pattern 31 and the second connection pattern 32, or may be in electrical contact with both the first connection pattern 31 and the third connection pattern 33, or may be in electrical contact with the first connection pattern 31, the second connection pattern 32 and the third connection pattern 33.

Alternatively, as shown in FIG. 1, the cathode layer 50 is in electrical contact with at least one of the first connection pattern 31, the second connection pattern 32 and the third connection pattern 33, which may be that the cathode layer 50 is in electrical contact with the first connection pattern 31, the second connection pattern 32 and the third connection pattern 33.

For example, the material of the cathode layer 50 may include indium zinc oxide (IZO) or magnesium-silver alloy.

In some examples, the cathode layer 50 may be formed by using a sputtering process.

In the display panel 100 provided in the embodiments of the present disclosure, the connection portion 30 includes the first connection pattern 31, the second connection pattern 32 and the third connection pattern 33, and the edge of the second connection pattern 32 is indented inward relative to the edge of the third connection pattern 33, so that after the connection portion 30 is formed, the light-emitting layer 40 is broken at the edge of the third connection pattern 33 of the connection portion 30 when the light-emitting layer 40 is formed, thereby forming the second light-emitting pattern 42 on the side of the third connection pattern 33 away from the substrate 10 and the first light-emitting pattern 41 located around the second light-emitting pattern 42.

In this way, the subsequently formed cathode layer 50 may pass through the gap between the first light-emitting pattern 41 and the second light-emitting pattern 42 to be in electrical contact with at least one of the first connection pattern 31, the second connection pattern 32 and the third connection pattern 33. That is, the cathode layer 50 may be electrically connected to the connection portion 30 to achieve parallel connection with the connection portion 30. In addition, the first connection pattern 31 of the connection portion 30 is electrically connected to the auxiliary electrode 20, so that the cathode layer 50 may be electrically connected to the auxiliary electrode 20. Thus, the cathode layer 50 and the auxiliary electrode 20 form a parallel structure, thereby reducing the resistance of the cathode layer 50, reducing the voltage drop on the cathode layer 50, improving the display effect of the display panel 100, and improving the brightness uniformity of the display panel 100.

In some embodiments, as shown in FIGS. 2 and 3A, the orthographic projection of the third connection pattern 33 on the substrate 10 is located inside the orthographic projection of the first connection pattern 31 on the substrate 10, and there is a distance d2 between the border of the orthographic projection of the third connection pattern 33 on the substrate 10 and the border of the orthographic projection of the first connection pattern 31 on the substrate 10.

The embodiments of the present disclosure do not limit the distance d2 between the border of the orthographic projection of the third connection pattern 33 on the substrate 10 and the border of the orthographic projection of the first connection pattern 31 on the substrate 10. It can be understood that, the distance d2 between the border of the orthographic projection of the third connection pattern 33 on the substrate 10 and the border of the orthographic projection of the first connection pattern 31 on the substrate 10 may be the same or different at different positions.

In this way, an area of the orthographic projection of the first connection pattern 31 on the substrate 10 is larger than an area of the orthographic projection of the third connection pattern 33 on the substrate 10, and an area of the orthographic projection of the second connection pattern 32 on the substrate 10 is smaller than the area of the orthographic projection of the first connection pattern 31 on the substrate 10. When the light-emitting layer 40 is broken at the border of the third connection pattern 33, not only may side surfaces of the second connection pattern 32 and the third connection pattern 33 be exposed, but also part of a surface of the first connection pattern 31 away from the substrate 10 may be exposed, so that the cathode layer 50 may be in contact with the surface of the first connection pattern 31 away from the substrate 10. Thus, the area of contact between the cathode layer 50 and the first connection pattern 31 may be larger, the contact between the cathode layer 50 and the first connection pattern 31 is more stable, and the contact resistance between the cathode layer 50 and the first connection pattern 31 is smaller.

The contact resistance between the cathode layer 50 and the first connection pattern 31 is smaller, so that the resistance of the cathode layer 50, the connection portion 30 and the auxiliary electrode 20 that are connected in parallel is smaller, and the voltage drop on the cathode layer 50 is also smaller. Thus, it is more beneficial to improve the display effect of the display panel 100 and improve the brightness uniformity of the display panel 100.

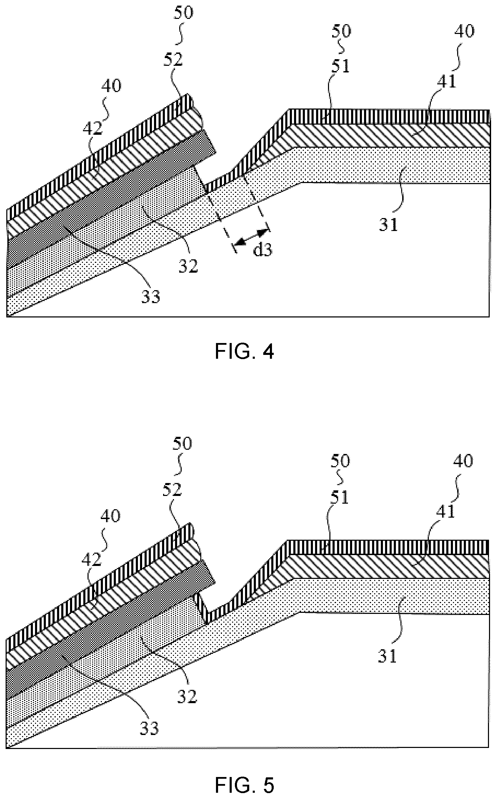

In some embodiments, as shown in FIG. 4, the cathode layer 50 can include a first contact portion 51 and a second contact portion 52. The first contact portion 51 is located on a side of the first light-emitting pattern 41 away from the substrate 10, and the second contact portion 52 is located on a side of the second light-emitting pattern 42 away from the substrate 10.

In some examples, the first contact portion 51 and the second contact portion 52 may be connected to each other. In some other examples, as shown in FIG. 4, the first contact portion 51 and the second contact portion 52 may be separated from each other.

In some examples, as shown in FIG. 4, there is a gap d3 between the second connection pattern 32 and the first light-emitting pattern 41, which exposes part of the surface of the first connection pattern 31. The first contact portion 51 covers a side surface of the first light-emitting pattern 41 proximate to the second connection pattern 32 and is in electrical contact with the exposed surface of the first connection pattern 31.

The gap d3 between the second connection pattern 32 and the first light-emitting pattern 41 is not limited in the embodiments of the present disclosure. Similarly, the size of the gap d3 between the second connection pattern 32 and the first light-emitting pattern 41 may be the same or different at different positions.

In this way, the first contact portion 51 of the cathode layer 50 is in electrical contact with the exposed surface of the first connection pattern 31, so that the electrical connection between the cathode layer 50 and the connection portion 30 is achieved, thereby achieving the electrical connection between the cathode layer 50 and the auxiliary electrode 20. The cathode layer 50 and the auxiliary electrode 20 form the parallel structure, so that the resistance of the cathode layer 50 may be reduced, and the voltage drop on the cathode layer 50 may be reduced. Thus, it is beneficial to improve the display effect of the display panel 100 and the brightness uniformity of the display panel 100.

It can be understood that a thickness of the first contact portion 51 may be the same or different at different positions. For example, a thickness of a portion of the first contact portion 51 that is in electrical contact with the exposed surface of the first connection pattern 31 and a thickness of a portion of the first contact portion 51 that is in contact with the first light-emitting pattern 41 may be different. The thickness of the portion of the first contact portion 51 that is in contact with the exposed surface of the first connection pattern 31 may be less than the thickness of the portion of the first contact portion 51 that is in contact with the first light-emitting pattern 41.

In some other examples, as shown in FIG. 5, the first contact portion 51 is in electrical contact with the side surface of the second connection pattern 32.

In this way, the first contact portion 51 of the cathode layer 50 is in electrical contact with the side surface of the second connection pattern 32, so that the electrical connection between the cathode layer 50 and the connection portion 30 may be achieved. Thus, the cathode layer 50 is electrically connected to the auxiliary electrode 20, so that the cathode layer 50 and the auxiliary electrode 20 form the parallel structure. The cathode layer 50 and the auxiliary electrode 20 form the parallel structure, so that the resistance of the cathode layer 50 may be relatively low, which is beneficial for reducing the voltage drop on the cathode layer 50, improving the display effect of the display panel 100, and improving the brightness uniformity of the display panel 100.

For example, the thickness of the portion of the first contact portion 51 that is in contact with the side surface of the second connection pattern 32 may be less than the thickness of the portion of the first contact portion 51 that is in contact with the first light-emitting pattern 41.

In some other examples, as shown in FIG. 5, the first contact portion 51 may be in electrical contact with the exposed surface of the first connection pattern 31 and in electrical contact with the side surface of the second connection pattern 32.

In this way, the first contact portion 51 is in electrical contact with the first connection pattern 31 and the second connection pattern 32 of the connection portion 30, so that the electrical contact between the cathode layer 50 and the connection portion 30 may be achieved. Thus, the electrical connection between the cathode layer 50 and the auxiliary electrode 20 is achieved. The cathode layer 50 and the auxiliary electrode 20 may form the parallel structure, which reduces the resistance of the cathode layer 50, and reduces the voltage drop on the cathode layer 50. Thus, it is beneficial to improve the display effect of the display panel 100 and the brightness uniformity of the display panel 100.

In addition, the first contact portion 51 is in electrical contact with both the first connection pattern 31 and the second connection pattern 32, so that the contact area between the cathode layer 50 and the connection portion 30 is relatively large, and the contact resistance between the cathode layer 50 and the connection portion 30 is smaller, which is beneficial to further reducing the voltage drop on the cathode layer 50, improving the display effect of the display panel 100, and improving the brightness uniformity of the image display of the display panel 100.

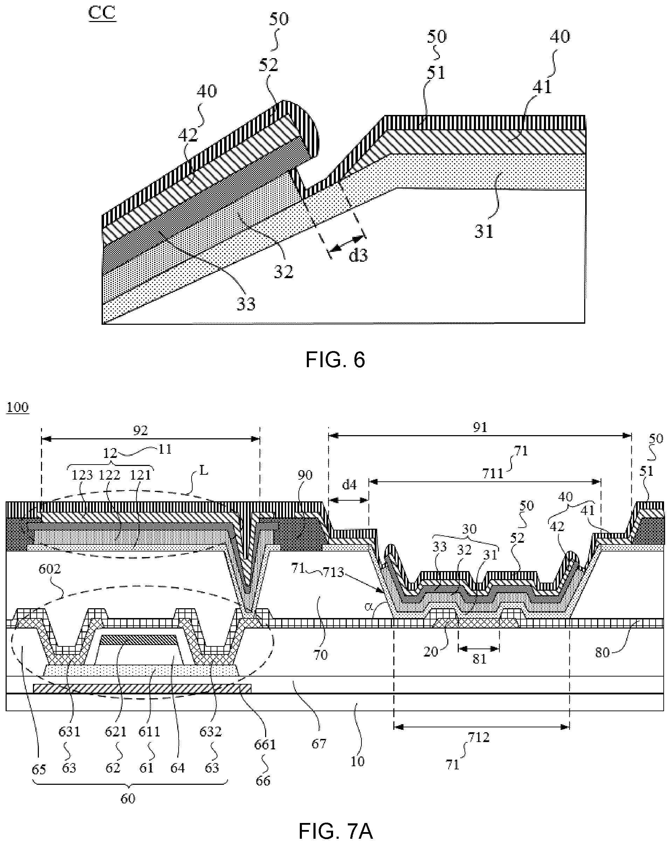

In some examples, as shown in FIG. 6, the second contact portion 52 covers a side surface of the second light-emitting pattern 42 proximate to the first light-emitting pattern 41 and is in electrical contact with a side surface of the third connection pattern 33.

In this way, the second contact portion 52 of the cathode layer 50 is in electrical contact with the side surface of the third connection pattern 33, so that the electrical connection between the cathode layer 50 and the entire connection portion 30 may be achieved. Thus, the cathode layer 50 may be electrically connected to the auxiliary electrode 20, so that the cathode layer 50 and the auxiliary electrode 20 form the parallel structure. The cathode layer 50 and the auxiliary electrode 20 form the parallel structure, so that the resistance of the cathode layer 50 may be reduced, and the voltage drop on the cathode layer 50 may also be reduced, which is beneficial for improving the display effect of the display panel 100, and improving the uniformity of the image display of the display panel 100.

For example, a thickness of the second contact portion 52 may be different at different positions. For example, a thickness of a portion of the second contact portion 52 that is in contact with the side surface of the third connection pattern 33 may be different from a thickness of a portion of the second contact portion 52 that is in contact with a surface of the second light-emitting pattern 42 away from the substrate 10.

In some other examples, as shown in FIG. 6, the first contact portion 51 may be in electrical contact with the exposed surface of the first connection pattern 31 and in electrical contact with the side surface of the second connection pattern 32, and the second contact portion 52 is in electrical contact with the side surface of the third connection pattern 33.

In this way, the first contact portion 51 is in electrical contact with the first connection pattern 31 and the second connection pattern 32, and the second contact portion 52 is in electrical contact with the third connection pattern 33, so that the electrical connection between the cathode layer 50 and the connection portion 30 is achieved. Thus, the electrical connection between the cathode layer 50 and the auxiliary electrode 20 is achieved. The cathode layer 50 and the auxiliary electrode 20 form the parallel structure, so that the resistance of the cathode layer 50 is reduced, and the voltage drop on the cathode layer 50 is reduced, which is beneficial for improving the display effect of the display panel 100, and improving the brightness uniformity of the display panel 100.

In addition, the first contact portion 51 is in electrical contact with both the first connection pattern 31 and the second connection pattern 32, and the second contact portion 52 is in electrical contact with the third connection pattern 33, so that the contact area between the cathode layer 50 and the connection portion 30 is larger, and the contact resistance between the cathode layer 50 and the connection portion 30 is smaller, which is beneficial to further reducing the voltage drop on the cathode layer 50, improving the display effect of the display panel 100, and improving the brightness uniformity of the image display of the display panel 100.

In some embodiments, as shown in FIG. 7A, the display panel 100 further includes a circuit structure layer 60 located between the connection portion 30 and the substrate 10. The circuit structure layer 60 includes a semiconductor layer 61, a gate layer 62, and a source-drain layer 63. The auxiliary electrode 20 is located in at least one layer of the semiconductor layer 61, the gate layer 62 and the source-drain layer 63.

The expression "the auxiliary electrode 20 is located in at least one layer of the semiconductor layer 61, the gate layer 62 and the source-drain layer 63" can be that the auxiliary electrode 20 is located in one layer of the semiconductor layer 61, the gate layer 62, and the source-drain layer 63 (for example, located in the source-drain layer 63 (as shown in FIG. 7A)).

Alternatively, the expression "the auxiliary electrode 20 is located in at least one layer of the semiconductor layer 61, the gate layer 62 and the source-drain layer 63" can be that the auxiliary electrode 20 is disposed in two layers of the semiconductor layer 61, the gate layer 62, and the source-drain layer 63. For example, the auxiliary electrode 20 is disposed in both the gate layer 62 and the source-drain layer 63.

Alternatively, the expression "the auxiliary electrode 20 is located in at least one layer of the semiconductor layer 61, the gate layer 62 and the source-drain layer 63" can be that the auxiliary electrode 20 is disposed in the semiconductor layer 61, the gate layer 62, and the source-drain layer 63.

Referring to FIG. 7A, the circuit structure layer 60 further includes a gate insulating layer 64 located between the semiconductor layer 61 and the gate layer 62, and an interlayer dielectric layer 65 located between the gate layer 62 and the source-drain layer 63.

Materials of the gate insulating layer 64 and the interlayer dielectric layer 65 may both be an insulating material. For example, the material of the gate insulating layer 64 may include silicon dioxide or silicon nitride, and the material of the interlayer dielectric layer 65 may also include silicon dioxide or silicon nitride.

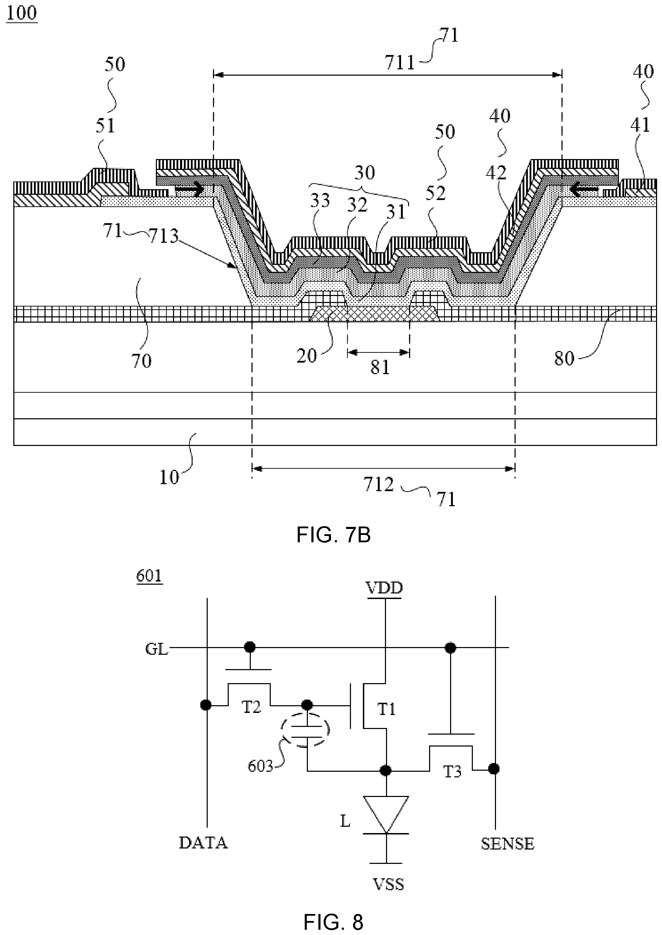

In some embodiments, as shown in FIGS. 7A and 8, the circuit structure layer 60 includes a pixel circuit 601, and the pixel circuit 601 includes a plurality of thin film transistors 602 and at least one storage capacitor 603.

Each thin film transistor 602 can include a semiconductor pattern 611, a gate 621, a source 631 and a drain 632. The semiconductor pattern 611 is located in the semiconductor layer 61, the gate 621 is located in the gate layer 62, and both the source 631 and the drain 632 are located in the source-drain layer 63. The source 631 and the drain 632 pass through the interlayer dielectric layer 65 and are in electrical contact with the semiconductor pattern 611.

For example, a material of the semiconductor pattern 611 may include polysilicon. Materials of the source 631, the drain 632, and the gate 621 may include metal, such as copper, aluminum, or molybdenum.

It can be understood that, in the case where the auxiliary electrode 20 is located in the gate layer 62, the auxiliary electrode 20 may be manufactured simultaneously with the gate 621 using the same photolithography process and using the same mask. Thus, there is no need to deposit additional film layers, the cost is reduced, and the manufacturing process of the display panel 100 is simplified.

Similarly, in the case where the auxiliary electrode 20 is located in the source-drain layer 63, the auxiliary electrode 20 may be manufactured simultaneously with the source 631 and the drain 632 using the same photolithography process and using the same mask. Thus, there is no need to deposit additional film layers, it is beneficial to reduce the cost, and the manufacturing process of the display panel 100 is simplified.

In the case where the auxiliary electrode 20 is located in the semiconductor layer 61, the auxiliary electrode 20 may be formed by semiconductor pattern doping metallization.

In some examples, as shown in FIG. 7A, the thin film transistor 602 may be a top-gate thin film transistor. In this case, the gate 621 is located on a side of the sem iconductor pattern 611 away from the substrate 10. That is, the gate layer 62 is located on a side of the semiconductor layer 61 away from the substrate 10.

In some other examples, the thin film transistor 602 may be a bottom-gate thin film transistor. In this case, the gate 621 is located between the semiconductor pattern 611 and the substrate 10. That is, the gate layer 62 is located between the semiconductor layer 61 and the substrate 10.

In some examples, the plurality of thin film transistors 602 in the pixel circuit 601 may all be N-type transistors. In some other examples, the plurality of thin film transistors 602 in the pixel circuit 601 may all be P-type transistors. In some other embodiments, part of the plurality of thin film transistors 602 in the pixel circuit 601 may be N-type transistors, and the other part of the plurality of thin film transistors 602 in the pixel circuit 601 may be P-type transistors.

The circuit structure of the pixel circuit 601 is not limited in the present disclosure, as long as the pixel circuit 601 can drive the light-emitting device to emit light. For example, the pixel circuit 601 may be of a 2T1C circuit structure, a 3T1C circuit structure, a 7T2C circuit structure, or the like.

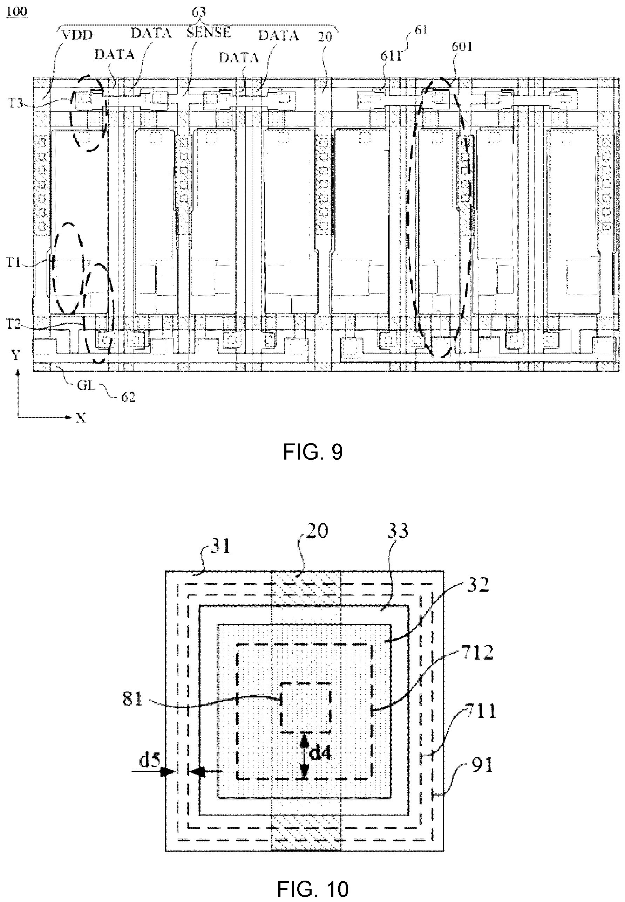

FIGS. 8 and 9 illustrate the pixel circuit 601 being of the 3T1C circuit structure. The pixel circuit 601 includes three thin film transistors 602, which are a transistor T1, a transistor T2, and a transistor T3. The source and drain of the transistor T1 are respectively connected to a high-level signal line VDD and the light-emitting device L, and the gate of the transistor T1 is connected to the drain of the transistor T2. The gate of the transistor T2 is connected to a gate line GL, and the source of the transistor T2 is connected to a data line DATA. The source of the transistor T3 is connected to the drain of the transistor T1, and the drain of the transistor T3 is connected to a sensing signal line SENSE.

The gate line GL is used to control the turning on and off of the transistor T2 during the display phase of the display panel 100; the data line DATA is used to provide a data voltage to the transistor T2; the high-level signal line VDD is used to provide a high-level voltage to the transistor T1; and the sensing signal line SENSE is used to receive an electrical signal from the drain of the transistor T2 or an electrical signal from the light-emitting device L, and transmit the electrical signal to the external circuit. The external circuit detects the characteristic change and uniformity of the transistor T1 according to the electrical signal at the drain of the transistor T2 or the electrical signal of the light-emitting device L, or detects the uniformity and aging degree of the light-emitting device L.

The gate line GL extends in the first direction X parallel to the substrate 10, and the high-level signal line VDD, the data line DATA, and the sensing signal line SENSE extend in the second direction Y parallel to the substrate 10. A portion, an orthographic projection of which on the substrate 10 overlaps with an orthographic projection of the semiconductor pattern 611 on the substrate 10, of the gate line GL serves as the gate of the thin film transistor 602.

In some embodiments, as shown in FIG. 9, the gate line GL may be composed of two parallel wires. In this way, in a case where one of the two parallel wires fails, the display panel 100 may also use the other wire to transmit the control signal. In addition, the gate line GL is composed of the two parallel lines, which may also reduce the resistance of the gate line GL and reduce the voltage drop on the gate line GL.

In some embodiments, as shown in FIG. 9, in the first direction X parallel to the substrate, one pixel circuit 601 may correspond to one data line DATA. One sensing signal line SENSE may be electrically connected to four pixel circuits 601 at the same time.

In some embodiments, as shown in FIG. 7A, the display panel 100 may further include a shielding layer 66 located between the substrate 10 and the semiconductor layer 61, and a buffer layer 67 located between the shielding layer 66 and the semiconductor layer 61.

For example, the shielding layer 66 includes a plurality of shielding patterns 661, and the orthographic projection of the semiconductor pattern 611 on the substrate 10 is at least partially overlapped with an orthographic projection of a shielding pattern 661 on the substrate 10. The shielding pattern 661 may be used to block external light or light reflected or refracted from the side of the substrate 10 to the semiconductor pattern 611 in the display panel 100, thereby ensuring the performance of the thin film transistor 602.

For example, an electrode plate of the storage capacitor 603 may also be disposed in the shielding layer 66.

For example, a material of the shielding layer 66 may include metal, such as copper or aluminum.

For example, a material of the buffer layer 67 may be an insulating material. For example, the material of the buffer layer 67 may include silicon oxide or silicon nitride.

In some embodiments, as shown in FIG. 7A, the display panel 100 further includes a planarization layer 70. The planarization layer 70 is located between the connection portion 30 and the auxiliary electrode 20. The planarization layer 70 includes a first through hole 71 exposing the auxiliary electrode 20. The first connection pattern 31 is in contact with the auxiliary electrode 20 through the first through hole 71.

A material of the planarization layer 70 may be an insulating material. For example, the material of the planarization layer 70 may be an organic insulating material, such as resin.

In some embodiments, as shown in FIG. 7A, the first through hole 71 includes a first end opening 711 and a second end opening 712. The first end opening 711 is farther away from the substrate 10 than the second end opening 712, and a size of the first end opening 711 is larger than a size of the second end opening 712.

A hole wall 713 of the first through hole 71 is inclined relative to the plane where the substrate 10 is located, and the edge of the second connection pattern 32 extends onto the hole wall 713 of the first through hole 71.

It can be understood that the first end opening 711 and the second end opening 712 of the same first through hole 71 have the same shape but different sizes. The shapes of the first end opening 711 and the second end opening 712 are not limited in the present disclosure. For example, as shown in FIG. 10, an orthographic projection of the first end opening 711 on the substrate 10 and an orthographic projection of the second end opening 712 on the substrate 10 can be substantially rectangular in shape (for example, rectangular in shape or square in shape).

The expression "an orthographic projection of the first end opening 711 on the substrate 10 and an orthographic projection of the second end opening 712 on the substrate 10 can be substantially rectangular in shape" means that the orthographic projection of the first end opening 711 on the substrate 10 and the orthographic projection of the second end opening 712 on the substrate 10 are in a shape of an overall rectangle, but it is not limited to a standard rectangle. That is, "rectangle" herein includes not only a standard rectangle but also a shape similar to a rectangle in consideration of process conditions.

In some examples, as shown in FIG. 10, the orthographic projection of the first end opening 711 on the substrate 10 and the orthographic projection of the second end opening 712 on the substrate 10 may be substantially square in shape.

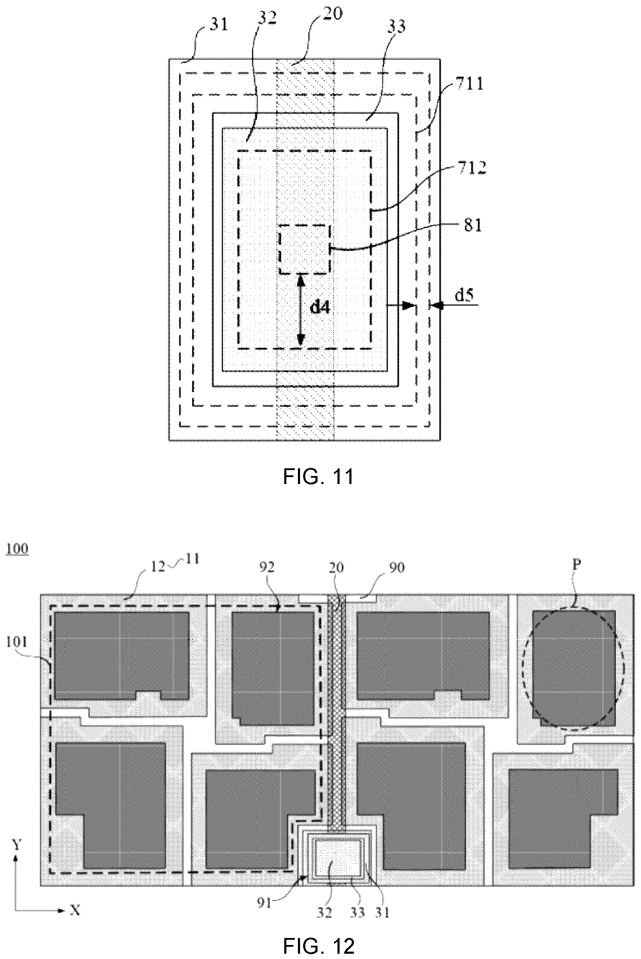

In some other examples, as shown in FIG. 11, the orthographic projection of the first end opening 711 on the substrate 10 and the orthographic projection of the second end opening 712 on the substrate 10 may be substantially rectangular in shape.

In some embodiments, as shown in FIG. 7A, there is an included angle α between the hole wall 713 of the first through hole 71 and the plane where the substrate 10 is located, and the included angle α is an acute angle.

In some examples, the included angle α between the hole wall 713 of the first through hole 71 and the plane where the substrate 10 is located is in a range of 25° to 50°. For example, the included angle α may be 25°, 30°, 35°, 40°, 45° or 50°.

With such arrangement, the included angle α between the hole wall 713 of the first through hole 71 and the plane where the substrate 10 is located is not too small, and when the cathode layer 50 is formed, the cathode layer 50 can easily pass through the gap between the first light-emitting pattern 41 and the second light-emitting pattern 42 to be in electrical contact with the second connection pattern 32 of the connection portion 30. In addition, the included angle α between the hole wall 713 of the first through hole 71 and the plane where the substrate 10 is located is not too large, which help avoid a situation where the light-emitting layer cannot be broken at the edge of the third connection pattern 33, or after the light-emitting layer is broken, the surface of the first connection pattern 31 away from the substrate 10 and the side surface of the second connection pattern 32 are covered by the first light-emitting pattern 41, and the side surface of the third connection pattern 33 is covered by the second light-emitting pattern 42, and in turn, help avoid a situation where the cathode layer 50 cannot be in electrical contact with the first connection pattern 31, the second connection pattern 32 and the third connection pattern 33.

The edge of the second connection pattern 32 extends onto the hole wall 713 of the first through hole 71, which may be that the edge of the orthographic projection of the second connection pattern 32 on the substrate 10 is located between the edge of the orthographic projection of the first end opening 711 on the substrate 10 and the edge of the orthographic projection of the second end opening 712 on the substrate 10 (as shown in FIG. 10).

In the embodiments of the present disclosure, the edge of the second connection pattern 32 extends onto the hole wall 713 of the first through hole 71, so that when the cathode layer 50 is formed, the cathode layer 50 can more easily pass through the gap between the first light-emitting pattern 41 and the second light-emitting pattern 42 to be in electrical contact with at least one of the first connection pattern 31, the second connection pattern 32, and the third connection pattern 33 of the connection portion 30. For example, the cathode layer 50 more easily pass through the gap between the first light-emitting pattern 41 and the second light-emitting pattern 42 to be in electrical contact with the second connection pattern 32.

It can be understood that, in the case where the edge of the second connection pattern 32 extends onto the hole wall 713 of the first through hole 71, the edge of the third connection pattern 33 may also extend onto the hole wall 713 of the first through hole 71.

In some embodiments, referring to FIG. 7A, the light-emitting layer 40 can be broken on the hole wall 713 of the first through hole 71, thereby forming the second light-emitting pattern 42 located on the side of the third connection pattern 33 away from the substrate 10, and the first light-emitting pattern 41 located around the second light-emitting pattern 42. The edge of the first light-emitting pattern 41 proximate to the second light-emitting pattern 42 extends onto the hole wall of the first through hole 71, and the edge of the second light-emitting pattern 42 proximate to the first light-emitting pattern 41 also extends onto the hole wall 713 of the first through hole 71.

In some embodiments, referring to FIG. 7A, the cathode layer 50 can be broken on the hole wall 713 of the first through hole 71 to form the first contact portion 51 and the second contact portion 52 that are separated from each other. In this case, the edges of the first contact portion 51 and the second contact portion 52 that are proximate to each other are located on the hole wall 713 of the first through hole 71. That is, the edge of the first contact portion 51 proximate to the second contact portion 52 is located on the hole wall 713 of the first through hole 71, and the edge of the second contact portion 52 proximate to the first contact portion 51 is also located on the hole wall 713 of the first through hole 71.

In this way, the first contact portion 51 and the second contact portion 52 of the cathode layer 50 are separated on the hole wall 713 of the first through hole 71, and the first contact portion 51 is more easily in contact with the side wall of the second connection pattern 32 and the surface of the first connection pattern 31 away from the substrate 10, and the second contact portion 52 is more easily in electrical contact with the side wall of the third connection pattern 33. Thus, the contact area between the cathode layer 50 and the connection portion 30 may be larger, the contact resistance between the cathode layer 50 and the connection portion 30 may be smaller, thereby making the total resistance value after the cathode layer and the auxiliary electrode 20 are connected smaller, and the voltage drop on the cathode layer 50 smaller, improving the brightness uniformity of the display panel, and improving the display effect of the display panel.

In some other embodiments, as shown in FIG. 7B, the edge of the second connection pattern 32 can also extend out of the first through hole 71, so as to be located on the surface of the planarization layer 70 away from the substrate 10.

In this case, the orthographic projection of the first end opening 711 on the substrate 10 is located within the orthographic projection of the second connection pattern 32 on the substrate 10, and there is a distance between the edge of the orthographic projection of the first end opening 711 on the substrate 10 and the orthographic projection of the second connection pattern 32 on the substrate 10.

It can be understood that, in the case where the edge of the second connection pattern 32 extends out of the first through hole 71, the edge of the third connection pattern 33 also extends out of the first through hole 71, so as to be located on the surface of the planarization layer 70 away from the substrate 10.

For example, the expression "the edge of the second connection pattern 32 is indented inward relative to the edge of the third connection pattern 33" can be that the edge of the second connection pattern 32 is indented inward relative to the edge of the third connection pattern 33 along the direction indicated by the "thick arrow" in FIG. 7B.

In some embodiments, as shown in FIGS. 7A and 7B, the display panel 100 can further include a passivation layer 80 located between the planarization layer 70 and the auxiliary electrode 20. The passivation layer 80 includes a second through hole 81 that exposes at least part of the surface of the auxiliary electrode 20. The second through hole 81 communicates with the first through hole 71. The first connection pattern 31 is in contact with the auxiliary electrode 20 through the first through hole 71 and the second through hole 81.

A material of the passivation layer 80 may be an insulating material. For example, the material of the passivation layer 80 may be an inorganic insulating layer, such as silicon oxide, silicon nitride, or silicon oxynitride.

The expression "the second through hole 81 exposes at least part of the surface of the auxiliary electrode 20" can be that the second through hole 81 exposes the entire surface of the auxiliary electrode 20, or, as shown in FIGS. 7A and 7B, the second through hole 81 exposes part of the surface of the auxiliary electrode 20.

In the case where the second through hole 81 exposes part of the surface of the auxiliary electrode 20, as shown in FIGS. 10 and 11, the orthographic projection of the second through hole 81 on the substrate 10 is located within the orthographic projection of the auxiliary electrode 20 on the substrate 10.

In some embodiments, as shown in FIGS. 10 and 11, the orthographic projection of the second through hole 81 on the substrate 10 is located inside the orthographic projection of the second end opening 712 of the first through hole 71 on the substrate 10, and there is a distance d4 between the border of the orthographic projection of the second through hole 81 on the substrate 10 and the border of the orthographic projection of the second end opening 712 on the substrate 10.

In the embodiments of the present disclosure, there is no limitation on the size of the distance d4 between the border of the orthographic projection of the second through hole 81 on the substrate 10 and the border of the orthographic projection of the second end opening 712 on the substrate 10. It can be understood that, the distance d4 between the border of the orthographic projection of the second through hole 81 on the substrate 10 and the border of the orthographic projection of the second end opening 712 on the substrate 10 may be different at different positions.

In this way, the size of the second through hole 81 is smaller than the size of the second end opening 712, the orthographic projection of the first through hole 71 on the substrate 10 overlaps with the orthographic projection of the second through hole 81 on the substrate 10, the total area of the orthographic projection of the first through hole 71 on the substrate 10 and the orthographic projection of the second through hole 81 on the substrate 10 is relatively small, and the occupied area of the non-light-emitting region where the first through hole 71 and the second through hole 81 are located is relatively small. Thus, it is beneficial to improve the aperture ratio of the display panel 100.

In some embodiments, as shown in FIGS. 10 and 11, the orthographic projection of the second through hole 81 on the substrate 10 is substantially rectangular in shape (including square and rectangular). It can be understood that the expression "the orthographic projection of the second through hole 81 on the substrate 10 is substantially rectangular in shape" means that the orthographic projection of the second through hole 81 on the substrate 10 is in a shape of an overall rectangle, but it is not limited to a standard rectangle. That is, "rectangle" herein includes not only a standard rectangle but also a shape similar to a rectangle in consideration of process conditions. FIGS. 10 and 11 show examples where the orthographic projection of the second through hole 81 on the substrate 10 is substantially square in shape.

In some embodiments, as shown in FIGS. 7A and 12, the display panel 100 further includes a pixel defining layer 90 located on a side of the connection portion 30 away from the substrate 10. The pixel defining layer 90 includes a third through hole 91 that exposes part of the surface of the first connection pattern 31 away from the substrate 10 and the side surfaces of the second connection pattern 32 and the third connection pattern 33. The light-emitting layer 40 is in contact with the first connection pattern and the third connection pattern 33 through the third through hole 91.

In some embodiments, as shown in FIGS. 7A and 12, the display panel 100 further includes an anode layer 11 located between the light-emitting layer 40 and the auxiliary electrode 20. The connection portion 30 is located in the anode layer 11. The anode layer 11 further includes an anode 12, and the pixel defining layer 90 further includes a pixel opening 92 that exposes part of a surface of the anode 12. The pixel opening 92 and the third through hole 91 are staggered from each other.

The connection portion 30 and the anode 12 are both located in the anode layer 11. The anode 12 and the connection portion 30 can be formed simultaneously. That is, the same mask is used when the anode 12 and the connection portion 30 are manufactured. Thus, the manufacturing cost of the display panel 100 may be reduced, and the manufacturing process of the display panel 100 is simplified.

The anode 12 can include a first anode layer 121, a second anode layer 122 and a third anode layer 123 that are sequentially stacked in the direction away from the substrate 10. The first anode layer 121 can be formed simultaneously with the first connection pattern 31, the second anode layer 122 can be formed simultaneously with the second connection pattern 32, and the third anode layer 123 can be formed simultaneously with the third connection pattern 33.

For example, as shown in FIG. 7A, the anode 12 may be electrically connected to the source 631 or the drain 632 of the thin film transistor 602 by passing through the planarization layer 70 and the passivation layer 80.

For example, as shown in FIG. 7A, the anode 12, the light-emitting layer 40, and the cathode layer 50 may form the above-mentioned light-emitting device L.

In some embodiments, as shown in FIGS. 10 and 11, in the case where the display panel 100 further includes the planarization layer 70 and the planarization layer 70 includes the first through hole 71, the orthographic projection of the first end opening 711 of the first through hole 71 on the substrate 10 is located inside the orthographic projection of the third through hole 91 on the substrate 10, and there is a distance d5 between the border of the orthographic projection of the first end opening 711 on the substrate 10 and the border of the orthographic projection of the third through hole 91 on the substrate 10.

The embodiments of the present disclosure do not limit the value of the distance d5 between the border of the orthographic projection of the first end opening 711 on the substrate 10 and the border of the orthographic projection of the third through hole 91 on the substrate 10. It can be understood that, the distance d5 between the border of the orthographic projection of the first end opening 711 on the substrate 10 and the border of the orthographic projection of the third through hole 91 on the substrate 10 may be different at different positions.

In this way, the orthographic projection of the first through hole 71 on the substrate 10 overlaps with the orthographic projection of the third through hole 91 on the substrate 10, the total area of the orthographic projection of the first through hole 71 on the substrate 10 and the orthographic projection of the third through hole 91 on the substrate 10 is relatively small, and the occupied area of the non-light-emitting region where the first through hole 71 and the third through hole 91 are located is relatively small. Thus, it is beneficial to improve the aperture ratio of the display panel 100.

In some embodiments, as shown in FIG. 12, the display panel includes a plurality of sub-pixels P that are arranged in rows along the first direction X and in columns along the second direction Y The first direction X intersects the second direction Y

For example, the plurality of sub-pixels P may display multiple colors. Based on this, the display panel 100 may include at least sub-pixels of a first color, sub-pixels of a second color and sub-pixels of a third color, and the first color, the second color and the third color may be three primary colors (e.g., red, green and blue).

In some examples, the display panel 100 may include sub-pixels of a first color, sub-pixels of a second color, sub-pixels of a third color, and sub-pixels of a fourth color; the first color, the second color and the third color are three primary colors (e.g., red, green and blue), and the fourth color are white.

For example, the sub-pixel P may include the above-mentioned pixel circuit 601 and light-emitting device L.

The display panel 100 can include a plurality of auxiliary electrodes 20. Embodiments of the present disclosure do not limit the number of the auxiliary electrodes 20. The number of the auxiliary electrodes 20 may be designed according to actual needs.

In some examples, at least one auxiliary electrode 20 extends in the first direction X and is located between two adjacent rows of sub-pixels P.

It can be understood that the expression "at least one auxiliary electrode 20 extends in the first direction X" may mean that one auxiliary electrode 20 extends along the first direction X. Alternatively, the expression "at least one auxiliary electrode 20 extends in the first direction X" may mean that multiple auxiliary electrodes 20 extend in the first direction X. In the case where multiple auxiliary electrodes 20 extend in the first direction X, all of the multiple auxiliary electrodes 20 may extend in the first direction X.

In some other examples, as shown in FIGS. 9 and 12, at least one auxiliary electrode 20 extends in the second direction Y and is located between two adjacent rows of sub-pixels P.

It can be understood that the expression "at least one auxiliary electrode 20 extends in the second direction Y" may mean that one auxiliary electrode 20 extends in the second direction Y. Alternatively, the expression "at least one auxiliary electrode 20 extends in the second direction Y" may mean that multiple auxiliary electrodes 20 extend in the second direction Y. In the case where multiple auxiliary electrodes 20 extend in the second direction Y, all of the multiple auxiliary electrodes 20 may extend in the second direction Y.

In yet some other examples, at least one auxiliary electrode 20 extends in the first direction X, and at least one auxiliary electrode 20 extends in the second direction Y. In this way, the auxiliary electrodes 20 may be distributed in a grid in the display panel, which is more beneficial to achieving the electrical connection between the auxiliary electrodes 20 and the cathode layer 50, reducing the resistance of the cathode layer 50, and reducing the voltage drop on the cathode layer 50. Thus, it is more beneficial to improve the uneven brightness of the display panel 100.

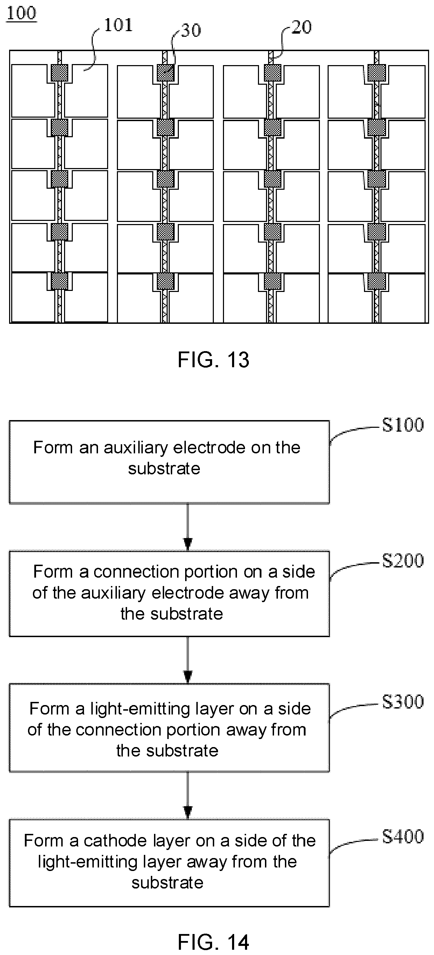

In some embodiments, as shown in FIGS. 12 and 13, the display panel 100 can include a plurality of pixels 101, and each pixel 101 includes sub-pixels P.

In some examples, the pixel 101 may include three sub-pixels P. In some other examples, as shown in FIG. 12, the pixel 101 may include four sub-pixels P. For example, the pixel 101 may include a blue sub-pixel, a green sub-pixel, a red sub-pixel, and a white sub-pixel.

In some embodiments, as shown in FIG. 13, the auxiliary electrodes 20 may be located between two adjacent rows of pixels 101. In some other embodiments, the auxiliary electrode 20 may be located between two adjacent columns of pixels 101. In yet some other embodiments, a part of the auxiliary electrodes 20 may be located between two adjacent rows of pixels 101, and another part of the auxiliary electrodes 20 may be located between two adjacent columns of pixels 101.

In some embodiments, as shown in FIG. 13, two adjacent auxiliary electrodes 20 may be separated by two columns of pixels 101. In some other embodiments, two adjacent auxiliary electrodes 20 may be separated by two rows of pixels 101.

In some embodiments, as shown in FIG. 13, one auxiliary electrode 20 is connected to first connection patterns 31 of multiple connection portions 30. In this way, there are multiple contact points between one auxiliary electrode 20 and the cathode layer 50, and different parts of the auxiliary electrodes 20 are respectively connected in parallel with the cathode layer 50, thereby further reducing the resistance of the cathode layer 50 and reducing the voltage drop on the cathode layer 50. Thus, it is more beneficial to improve the uneven brightness of the display panel 100.

As shown in FIG. 14, some embodiments of the present disclosure further provide a manufacturing method of a display panel 100, and the manufacturing method includes the following.

In S100, an auxiliary electrode 20 is formed on the substrate 10.

For example, a conductive layer may be deposited on the substrate 10, and the conductive layer is patterned to form the auxiliary electrode 20.

In S200, a connection portion 30 is formed on a side of the auxiliary electrode 20 away from the substrate 10. The connection portion 30 includes a first connection pattern 31, a second connection pattern 32, and a third connection pattern 33 that are sequentially stacked in a direction away from the substrate 10. The first connection pattern 31 is electrically connected to the auxiliary electrode 20, and an edge of the second connection pattern 32 is indented inward relative to an edge of the third connection pattern 33.

In S300, a light-emitting layer 40 is formed on a side of the connection portion 30 away from the substrate 10. The light-emitting layer 40 is broken at the border of the third sub-layer to form a second light-emitting pattern 42 on the third connection pattern 33 and a first light-emitting pattern 41 located around and separated from the second light-emitting pattern 42.

In S400, a cathode layer 50 is formed on a side of the light-emitting layer 40 away from the substrate 10.

In the manufacturing method of the display panel 100 provided in the embodiments of the present disclosure, the formed connection portion 30 includes the first connection pattern 31, the second connection pattern 32 and the third connection pattern 33, and the edge of the second connection pattern 32 is indented inward relative to the edge of the third connection pattern 33, so that the light-emitting layer 40 may be broken at the edge of the third connection pattern 33 of the connection portion 30 when the light-emitting layer 40 is formed, thereby forming the second light-emitting pattern 42 on the third connection pattern 33 and the first light-emitting pattern 41 located around the second light-emitting pattern 42. In this way, in the subsequent process of forming the cathode layer 50, the cathode layer 50 may pass through the gap between the first light-emitting pattern 41 and the second light-emitting pattern 42 to be in electrical contact with at least one of the first connection pattern 31, the second connection pattern 32 and the third connection pattern 33.

With such arrangement, the cathode layer 50 is electrically connected to the connection portion 30, so that the cathode layer 50 may be electrically connected to the auxiliary electrode 20, and the cathode layer 50 may form a parallel structure with the auxiliary electrode 20. Thus, the resistance of the cathode layer 50 is reduced, the voltage drop on the cathode layer 50 is reduced, the display effect of the display panel 100 is improved, and the brightness uniformity of the display panel 100 is improved.

In some embodiments, forming the connection portion 30 on the side of the auxiliary electrode 20 away from the substrate 10 in S200 may include the following.

A first conductive layer is formed on the side of the auxiliary electrode 20 away from the substrate 10, and the first conductive layer is patterned to form the first connection pattern 31. It can be understood that, in the case where the connection portion 30 is located in the anode layer 11, the first conductive layer is patterned to form the first connection pattern 31, and at the same time, a first anode layer 121 of the anode 12 may also be formed.

A second conductive layer and a third conductive layer are formed sequentially on a side of the first conductive layer away from the substrate. The third conductive layer is patterned to form the third connection pattern 33. The second conductive layer is patterned to form the second connection pattern 32.

For example, a wet etching process may be used to pattern the second conductive layer and the third conductive layer. It can be understood that etching solutions used to pattern the second conductive layer and the third conductive layer are different. The second conductive layer may be over-etched by controlling the process condition (e.g., etching time) of wet etching, so that the edge of the second connection pattern 32 is indented inward relative to the edge of the third connection pattern 33.

In some embodiments, after forming the auxiliary electrode 20 on the substrate 10 in step S100, the manufacturing method of the display panel may include: forming a passivation layer 80 on the side of the auxiliary electrode 20 away from the substrate 10; and forming a planarization layer 70 on a side of the passivation layer 80 away from the substrate 10. The planarization layer 70 is etched to form a first through hole 71, and the first through hole 71 exposes part of the surface of the passivation layer 80 away from the substrate 10. The exposed surface of the passivation layer 80 is etched to form a second through hole 81. The second through hole 81 exposes at least part of the surface of the auxiliary electrode 20 away from the substrate 10.

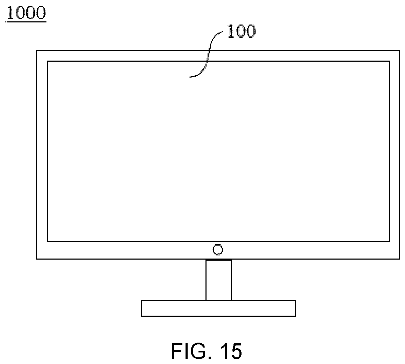

As shown in FIG. 15, some embodiments of the present disclosure provide a display apparatus 1000, and the display apparatus 1000 includes the display panel 100 described in any of the above embodiments.

The display apparatus 1000 may be any component with a display function, such as a television, a digital camera, a mobile phone, a watch, a tablet computer, a notebook computer, or a navigator.

Beneficial effects that can be achieved by the display apparatus 1000 provided in the present disclosure are the same as the beneficial effects that can be achieved by the display panel 100 described in any of the above embodiments.

The foregoing descriptions are merely specific implementations of the present disclosure, but the protection scope of the present disclosure is not limited thereto, any changes or replacements that a person skilled in the art could conceive of within the technical scope of the present disclosure shall be included in the protection scope of the present disclosure. Therefore, the protection scope of the present disclosure should be determined by the protection scope of the claims.

## Claims

1. A display panel, comprising:
a substrate;
an auxiliary electrode located on the substrate;
a connection portion located on a side of the auxiliary electrode away from the substrate, wherein the connection portion includes a first connection pattern, a second connection pattern, and a third connection pattern that are sequentially stacked in a direction away from the substrate; the first connection pattern is electrically connected to the auxiliary electrode, and an edge of the second connection pattern is indented inward relative to an edge of the third connection pattern;
a light-emitting layer including a first light-emitting pattern and a second light-emitting pattern, wherein the first light-emitting pattern is located around and separated from the second light-emitting pattern, and the second light-emitting pattern is located on a side of the third connection pattern away from the substrate; and
a cathode layer located on a side of the light-emitting layer away from the substrate, wherein the cathode layer passes through a gap between the first light-emitting pattern and the second light-emitting pattern to be in electrical contact with at least one of the first connection pattern, the second connection pattern and the third connection pattern.

2. The display panel according to claim 1, wherein
an orthographic projection of the third connection pattern on the substrate is located inside an orthographic projection of the first connection pattern on the substrate, and a distance exists between a border of the orthographic projection of the third connection pattern on the substrate and a border of the orthographic projection of the first connection pattern on the substrate.

3. The display panel according to claim 1 or 2, further comprising:
a circuit structure layer located between the connection portion and the substrate, wherein the circuit structure layer includes a semiconductor layer, a gate layer and a source-drain layer; and the auxiliary electrode is located in at least one layer of the semiconductor layer, the gate layer and the source-drain layer.

4. The display panel according to any one of claims 1 to 3, wherein the cathode layer includes:
a first contact portion located on a side of the first light-emitting pattern away from the substrate; and
a second contact portion located on a side of the second light-emitting pattern away from the substrate.

5. The display panel according to claim 4, wherein a gap exists between the second connection pattern and the first light-emitting pattern, and the gap exposes part of a surface of the first connection pattern; the first contact portion covers a side surface of the first light-emitting pattern proximate to the second connection pattern and is in electrical contact with an exposed surface of the first connection pattern; and/or
the first contact portion is in electrical contact with a side surface of the second connection pattern.

6. The display panel according to claim 4 or 5, wherein the second contact portion covers a side surface of the second light-emitting pattern proximate to the first light-emitting pattern and is in electrical contact with a side surface of the third connection pattern.

7. The display panel according to any one of claims 4 to 6, wherein the first contact portion and the second contact portion are separated from each other.

8. The display panel according to any one of claims 1 to 7, further comprising:
a planarization layer located between the connection portion and the auxiliary electrode, wherein the planarization layer includes a first through hole exposing the auxiliary electrode; and the first connection pattern is in contact with the auxiliary electrode through the first through hole.

9. The display panel according to claim 8, wherein
the first through hole includes a first end opening and a second end opening, the first end opening is farther away from the substrate than the second end opening, and a size of the first end opening is larger than a size of the second end opening; and
a hole wall of the first through hole is inclined relative to a plane where the substrate is located, and the edge of the second connection pattern extends onto the hole wall of the first through hole.

10. The display panel according to claim 9, wherein the cathode layer includes a first contact portion and a second contact portion that are separated from each other, and edges of the first contact portion and the second contact portion that are proximate to each other are located on the hole wall of the first through hole.

11. The display panel according to any one of claims 8 to 10, further comprising:
a passivation layer located between the planarization layer and the auxiliary electrode, wherein the passivation layer includes a second through hole that exposes at least part of a surface of the auxiliary electrode, and the second through hole communicates with the first through hole; and
the first connection pattern is in contact with the auxiliary electrode through the first through hole and the second through hole.

12. The display panel according to claim 11, wherein
an orthographic projection of the second through hole on the substrate is located inside an orthographic projection of the auxiliary electrode on the substrate.

13. The display panel according to claim 11 or 12, wherein an orthographic projection of the second through hole on the substrate is located inside an orthographic projection of the second end opening of the first through hole on the substrate, and a distance exists between a border of the orthographic projection of the second through hole on the substrate and a border of the orthographic projection of the second end opening on the substrate.

14. The display panel according to any one of claims 11 to 13, wherein
an orthographic projection of the second through hole on the substrate is rectangular in shape, and an orthographic projection of the second end opening of the first through hole on the substrate is rectangular in shape.

15. The display panel according to any one of claims 1 to 14, further comprising:
a pixel defining layer located on a side of the connection portion away from the substrate, wherein the pixel defining layer includes a third through hole that exposes part of a surface of the first connection pattern away from the substrate and side surfaces of the second connection pattern and the third connection pattern;
wherein the light-emitting layer is in contact with the first connection pattern and the third connection pattern through the third through hole.

16. The display panel according to claim 15, further comprising:
an anode layer located between the light-emitting layer and the auxiliary electrode, wherein the connection portion is located in the anode layer; the anode layer further includes an anode; the pixel defining layer further includes a pixel opening exposing part of a surface of the anode; and the pixel opening and the third through hole are staggered from each other.

17. The display panel according to claim 15 or 16, wherein in a case where the display panel further comprises a planarization layer and the planarization layer includes a first through hole,
an orthographic projection of a first end opening of the first through hole on the substrate is located inside an orthographic projection of the third through hole on the substrate, and a distance exists between a border of the orthographic projection of the first end opening on the substrate and a border of the orthographic projection of the third through hole on the substrate.

18. The display panel according to any one of claims 1 to 17, wherein the display panel comprises a plurality of sub-pixels that are arranged in rows along a first direction and in columns along a second direction; the first direction intersects the second direction;
the display panel comprises a plurality of auxiliary electrodes;
at least one auxiliary electrode extends in the first direction and is located between two adjacent rows of sub-pixels; and/or
at least one auxiliary electrode extends in the second direction and is located between two adjacent columns of sub-pixels.

19. The display panel according to claim 18, wherein one auxiliary electrode is connected to first connection patterns of multiple connection portions.

20. A display apparatus, comprising the display panel according to any one of claims 1 to 19.
